# EUROPÄISCHE PATENTSCHRIFT

(11) **EP 1 960 309 B1**
(45) Veröffentlichungstag und Bekanntmachung des Hinweises auf die Patenterteilung: **06.01.2010**
(21) Anmeldenummer: 06818093.4
(22) Anmeldetag: 24.11.2006
(51) Int. Cl.: B82B 3/00, C30B 29/60, C30B 7/00

(54) **VERFAHREN ZUR HERSTELLUNG VON NANOSTRUKTUREN AUF EINEM SUBSTRAT**
METHOD FOR PRODUCING NANOSTRUCTURES ON A SUBSTRATE
PROCÉDÉ DE FABRICATION DE NANOSTRUCTURES SUR UN SUBSTRAT

(30) Priorität: 15.12.2005 DE 102005060407
(43) Veröffentlichungstag der Anmeldung: 27.08.2008
(73) Patentinhaber: Christian-Albrechts-Universität zu Kiel, 24118 Kiel (DE)
(72) Erfinder: ELBAHRI, Mady, 24104 Kiel (DE); ADELUNG, Rainer, 24118 Kiel (DE); PARETKAR, Dadichi, Ranapratap Nagar Nagpur 440022 (IN)
(74) Vertreter: Biehl, Christian
(86) Internationale Anmeldenummer: PCT/DE2006/002066
(87) Internationale Veröffentlichungsnummer: WO 2007/076745

(56) Entgegenhaltungen:
- WO-A-2004/088005
- US-A- 5 858 862
- SATOSHI YAMABI ET AL.: "Growth conditions for wurtzite zinc oxide films in aqueous solutions" J. MATERIALS CHEMISTRY, Bd. 12, 2002, Seiten 3773-3778, XP002430606
- TSAPIS ET AL: "Onset of buckling in drying colloidal suspensionsu" PHYSICAL REVIEW LETTERS, Bd. 94, 2005, Seiten 018302-1-018302-4, XP002430607 in der Anmeldung erwähnt
- WENZHONG WANG ET AL: "Low temperature solvothermal synthesis of mutliwall carbon nanotubes" NANOTECHNOLOGY, Bd. 16, 2005, Seiten 21-23, XP002430608

## Beschreibung

Die Erfindung betrifft ein Verfahren zur Herstellung von Nanostrukturen auf einem Substrat. Die Erfindung betrifft insbesondere die Herstellung von Nanodrähten bzw. lineare Anordnungen von Nanodots (Cluster) sowie das Erzeugen von Kohlenstoff-Nanoröhren unmittelbar auf einem weitgehend beliebigen Träger. Die Erfindung betrifft auch das Erzeugen von Nanostrukturen auf Silizium-Wafern, insbesondere auf MEMS oder Mikrochips.

Nanostrukturen wie Nanodrähte und Nanoröhren stehen zurzeit im Fokus aktueller Forschung. Sie repräsentieren eine Klasse von Materialen, die u. a. aufgrund von Quanteneffekten neuartige elektrische, optische, magnetische und thermodynamische Eigenschaften aufweisen. Neben den vorrangig akademischen Fragen stellt sich dabei auch das Problem der reproduzierbaren Massenfertigung mit möglichst einfachen Mitteln, um zeitnah den Bereich der gewerblichen Nutzung von Nanostrukturen auszubauen.

Zwar sind einfache Verfahren zur Erzeugung von Nanopartikelaggregaten bekannt (z.B. siehe Tsapis et al., "Onset of Buckling in Drying Droplets of Colloidal Suspension", Physical Review Letters, 94, 018302-1 - 018302-4, 2005), jedoch ist die Erzeugung von großflächig geordneten Nanostrukturen auf der Oberfläche eines Substrats ist bis heute ein schwieriger Prozess, der üblich mit mehreren Schritten und hohen Kosten verbunden ist. Typische Verfahren für die Herstellung solcher Strukturen sind Vapour Liquid Solid (VLS) oder MOCV Verfahren. Zwar sind diese Verfahren relativ universell anwendbar, aber sowohl die Kontrolle der Atmosphäre (UHV) als auch die Notwendigkeit hoher Temperaturen (600-1000 °C) verlangen teures Equipment und machen die Synthese zeitaufwendig. Vorstrukturierte Substrate wie z.B. MEMS können solch hohen Temperaturen nicht ohne weiteres ausgesetzt werden.

Zur Reduktion des Aufwandes kennt der Fachmann auch nasschemischen Herstellungsverfahren aus wässriger Lösung, die bei Temperaturen unter 100 C° und bei Atmosphärendruck zu den gewünschten Ergebnissen führen (z.B. siehe Law et al., "Nanowire dye-sensitized solar cells", nature materials, 4, 455-459, 2005 und Satoshi et al. "growth conditions for wurtzite zinc oxide film in aqueous solutions", J Mat. Chem, 12, 2002, seiten 3773-3778). Allerdings haben die nasschemischen Methoden neben ihrem sehr langsamen Ablauf (Prozesszeiten von mehreren Stunden bis Tagen) andere Nachteile. So ist etwa kein epitaktisches Wachstum auf Silizium möglich (siehe J. Phys. Chem. B 2001, 105, 3350-3352). Außerdem kommen in manchen Fällen auch Lösungsmittel zum Einsatz, die ein Entsorgungsproblem mit sich bringen.

Beispielsweise ist man heute sehr an der Herstellung von Zinkoxid (ZnO) Nanostrukturen, etwa Nanostäbchen und Nanoröhren, interessiert. Dies ist schon deshalb der Fall, weil ZnO als Halbleiter eine große Variation an Nanostrukturen, bilden kann. Überdies werden vielseitige Anwendungen als optoelektronische Bauteile, Laser, Feldemissions- und Gassensor-Materialien erwogen (zur Herstellung und Anwendung von Nanoröhren und Nanostäbchen siehe auch Advanced Materials 2005, 17, 2477). Um nun ZnO-Strukturen epitaktisch zu erzeugen werden entweder spezielle Substrate wie Galliumnitrid (GaN) benutzt oder Silizium-Substrate mit einem sogenannten "Seeding Layer" beschichtet, der meistens aus einem bei 400 C° erhitzten ZnO Dünnfilm besteht. Eine direkte nicht eptitaktische Herstellung großflächig nanostrukturierter ZnO-Strukturen auf Substraten ist bislang noch nicht bekannt.

Ein anderes Beispiel sind die Kohlenstoff Nanoröhren (Carbon Nano Tubes, CNT), die als "smart material" bezeichnet werden. Diese haben ihre Anwendung u. a. in Brennstoffzellen, Bio-Gas Sensoren, Feldeffekt-Transistoren. Auch hier weisen die bekannten Herstellungsverfahren (Lichtbogen, Laser, CVD, PECVD) einen hohen technischen Aufwand auf (hohe Temperatur, Vakuum, etc.). Ein alternatives, solvothermales Syntheseverfahren bei Niedrigtemperatur (310C°) löst zwar dieses Problem (Wang et al., Nanotechnology 16, 21-23, 2005), allerdings braucht der Prozess immer noch etwa 20-40 Stunden bei geringer Ausbeute.

Ein drittes Beispiel sind wasserlösliche Nanostrukturen aus anorganischen Materialen wie etwa CaC03, BaC03, die sich mit ungewöhnlichen mechanischen und optischen Eigenschaften für neue Anwendungen in der Biotechnologie empfehlen. Die kontrollierte Herstellung solcher Materialen erfolgt durch Mischung von Salzen mit Polymeren (Biopolymeren, siehe Shu et al., nature materials 4, 51, 2005). Drähte aus solchem Material, die einen Durchmesser von weniger als 100 nm zeigen, sind noch nicht bekannt.

Ein noch wichtigeres Beispiel ist die Herstellung von Nanodrähten, die aus Nanoclustern bestehen. Es ist bereits bekannt, dass die Anordnung von Nanoclustern in 1D, 2D oder 3D zur neuen Eigenschaften führen kann, die bei ungeordneten Clustern nicht auftreten und die auf der Nächstnachbarwechselwirkung zwischen den Clustern beruhen, wie etwa Magnitization Flip (Anwendung: Datenspeicherung) und plasmonische Leitfähigkeit (Anwendung: Lichtleiter) (vgl. z.B. als Quellen: nature materials, 2, 229, 2003 oder Eur. J. Inorg. Chem. 2455, 2001).

Im Gegensatz zur bekannten und einfachen Anordnung von Nanoteilchen in 2D und 3D ist die 1D Anordnung ein komplizierter Vorgang, bei dem typischerweise ein Template (z.B. Maske, Gießform) verwendet werden muss. Dieses Template limitiert die verwendeten Materialien und fünrt möglicherweise zu Störungen des aus den Clustern entstehenden Nanodrahtes (etwa bei der Entfernung des Templates) oder seinen Eigenschaften (z.B. wenn ein Nanodraht als Sensor benutzt wird, so kann nicht vollständig entferntes Template-Material die Sensitivität herabsetzen).

So haben die verschiedenen Prozesse, die benutzt werden um Nanostrukturen herzustellen, nicht selten gemeinsame Nachteile wie Aufwendigkeit, hohe Kosten, geringe Geschwindigkeit.

Daher ist es die Aufgabe der Erfindung, ein Verfahren zur Erzeugung von Nanostrukturen auf einem weitgehend beliebigen Substrat anzugeben, das ohne teures Equipment schon nach sehr kurzer Prozessdauer zu großer Ausbeute und großflächiger Bedeckung führt.

Die Aufgabe wird gelöst durch ein Verfahren mit den Merkmalen des Hauptanspruchs. Die Unteransprüche geben vorteilhafte Ausgestaltungen der Erfindung an.

Das erfindungsgemäße Verfahren unterscheidet sich von allen dem Fachmann bekannten Verfahren zur Erzeugung von Nanostrukturen dadurch, dass es nicht auf einer allmählichen, selbstorganisierten Bildung dieser Strukturen aus ihren Konstituenten beruht, wie dies etwa bei epitaktischem Wachstum der Fall ist. Vielmehr bildet ein hoch instabiler, von Nichtgleichgewichtsreaktionen gekennzeichneter Zustand den Ausgangspunkt des Nanodrahtwachstums im hier beschriebenen Verfahren. Die Erfindung macht sich einen Natureffekt zunutze, der bis jetzt nicht völlig verstanden ist. Gleichwohl liefert das Verfahren sehr gut reproduzierbare Resultate und scheint für eine Reihe von verschiedenen Materialien zu funktionieren, von denen naturgemäß nur eine Auswahl experimentell überprüft werden kann, was aber die Erfindung natürlich nicht einschränken soll.

Das erfindungsgemäße Verfahren umfasst im Wesentlichen die Schritte:
1. Einbringen eines eine Nanostruktur bildenden. Materiales in Wasser zur Erzeugung einer Lösung.
2. Gegebenenfalls Zugabe von Katalysator-Partikeln in die Lösung.
3. Aufheizen des Substrats auf Temperaturen oberhalb 200 °C.
4. Zugabe einzelner Tropfen der Lösung auf das geheizte Substrat.
5. Es erfolgt ein Verdampfen der Tropfen unter Nutzung des Leidenfrost-Effekts, bei dem sich Nanostrukturen bilden und auf dem Substrat abgeschieden werden.
6. Gegebenenfalls wird das Substrat geneigt, so dass ein der Schwerkraft folgender, bewegter Tropfen Nanostrukturen entlang seines Weges deponiert.

Es scheint für die Bildung der Nanostrukturen notwendig zu sein, dass die Lösung lokal explosionsartig verdampft. Dabei scheint der Leidenfrost-Effekt eine wichtige Rolle zu spielen, demzufolge ein Wassertropfen, der auf eine Heizplatte fällt, auf einem Wasserdampfpolster schwebt und gleitet, wodurch seine Verdampfung etwas verzögert wird. Der Effekt tritt auf, wenn die Heizplatte eine Temperatur jenseits der Leidenfrost-Temperatur aufweist, die bei Normaldruck für Wasser etwas oberhalb von 200°C liegt. Unabhängig von der Frage nach der Reaktionskinetik, die derzeit ungeklärt bleibt, ist es äußerst vorteilhaft, wenn nicht sogar notwendig, den Leidenfrost-Effekt beim Auftropfen der Material-Lösung auszunutzen. Denn durch das Gleiten des Tropfens über das Substrat wird eine gleichmäßige Verteilung der abgeschiedenen Nanostrukturen begünstigt und ggf. auch eine größere Fläche bedeckt.

Die experimentellen Befunde beweisen, dass sich die ersten Nanostruktur-Gebilde großflächig - im Bereich des aufgebrachten Tropfens - innerhalb weniger Sekunden gebildet haben. Dabei ist besonders hervorzuheben, dass dieselben Verfahrensschritte zur Erzeugung sehr verschiedener Strukturen, die sich z. T. sogar gleichzeitig bilden, dienen können. Die vielfältigen Erzeugnisse des erfindungsgemäßen Verfahrens sollen im Folgenden anhand von Rasterelektronenmikroskop-Aufnahmen illustriert und näher erläutert werden.

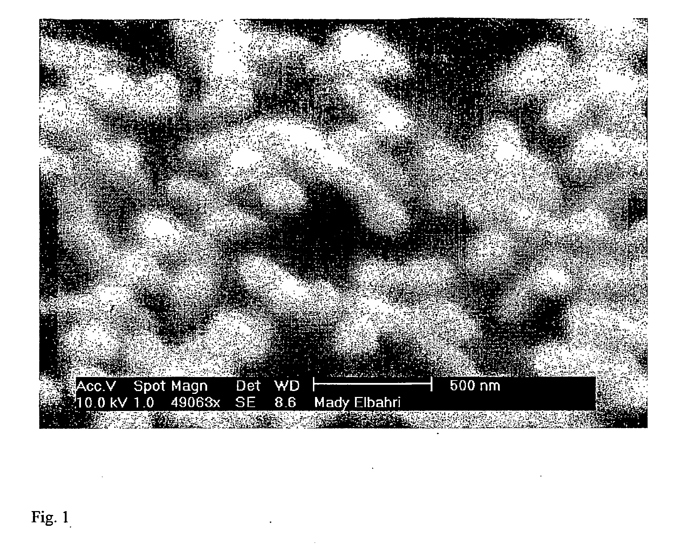

In Fig. 1 sind Zinkoxid-Nanostäbchen zu sehen, die unmittelbar durch das Verdampfen von Tropfen einer wässrigen 0,02 M Zinkacetat-Lösung gebildet werden. Das geheizte SiliziumSubstrat benötigt hierfür keinen "seeding layer" und es werden keine Katalysatoren eingesetzt. Die abgebildeten Strukturen sind nach 2-3 Minuten Prozessdauer entstanden und bedecken das Substrat großflächig im Bereich der zuvor vom Tropfen benetzten Oberfläche. ZnO bildet sich aus den Zink-Ionen der Lösung und vermutlich dem Sauerstoff der Umgebungsluft. Heizt man das Substrat nur auf Temperaturen zwischen 25 und 200 °C, so entstehen keine Nanostrukturen, sondern lediglich ein dünner Film.

Eine bevorzugte Ausgestaltung der Erfindung besteht in der Zugabe von Katalysator-Partikeln, vorzugsweise von Edelmetall-Nanopartikeln. Besonders bevorzugt werden Goldpartikel mit einem Durchmesser um 20 nm zur oben beschriebenen wässrigen Lösung mit Nanostruktur-Material gegeben.

Die Goldpartikel selbst sind in gelöster und durch organische wie auch anorganische Zusätze stabilisierter Form als Lösung von der Firma Aldrich kommerziell erhältlich. Die Stabilisierung verhindert die Agglomeration der Partikel und ist unverzichtbar. Wie sich zeigt, tendieren auch die kohlenstoffhaltigen Stabilisatoren mehr oder weniger unvermeidlich zur Bildung von Nanostrukturen bei Nutzung des erfindungsgemäßen Verfahrens.

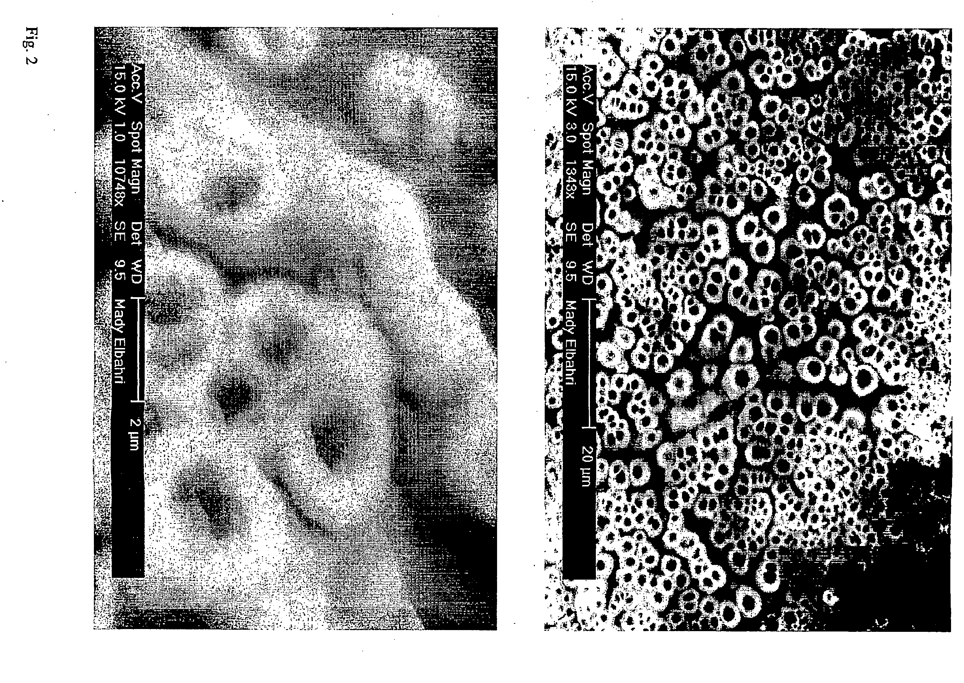

Fig. 2 zeigt Zinkoxid-Nanoröhren, die sich infolge der Beimengung von Katalysatorpartikeln (ZnO-Lösung mit Aldrich-Lösung im Verhältnis 1:3) nach wenigen Minuten bilden. Fig. 2 unten ist eine Ausschnittsvergrößerung des oberen Bildes, um die Röhrenstruktur deutlicher darzustellen. Auch hier lässt sich das gezeigte Ergebnis nicht erzielen, wenn das Substrat unter 200 °C geheizt oder nur allmählich erwärmt wird.

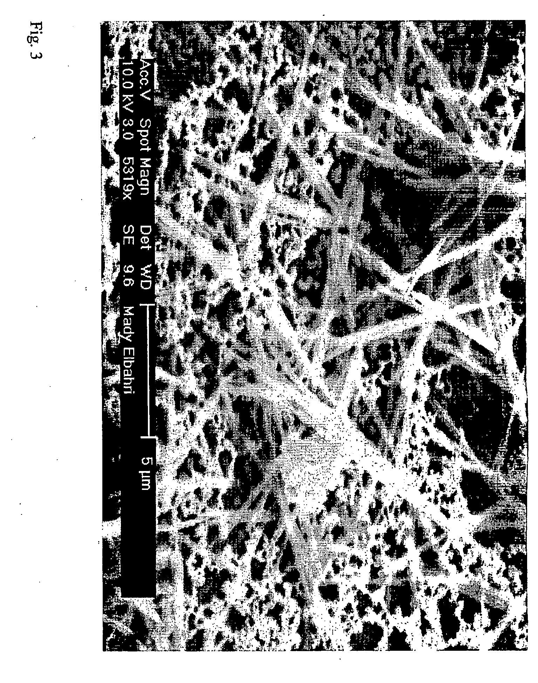

Ein interessanter Nebeneffekt der Beimengung der Katalysatorpartikel betrifft den Verbleib des Goldes auf dem Substrat. Das Gold kann beim Entfleuchen des Wassers von der Heizplatte nicht entkommen, wird aber scheinbar nicht ohne weiteres in die bisher genannten Nanostrukturen eingebaut. Vielmehr findet man, dass das Gold, selbst ein fraktal anmutendes, aber doch gleichmäßig verteiltes Goldnetz auf dem Substrat bildet, das noch unter anderen Nanostrukturen (hier: abstehende Drähte, s. u.) angeordnet ist, wie Fig. 3 belegt. Ob dieses Netzwerk auch eine Rolle für die Bildung komplexerer Nanostrukturen spielt, ist noch ungewiss. Das Goldnetz lässt sich beispielsweise mit einer Lösung von 0,03 M ZnO in 0,1 M NaOH unter Beimengung der Aldrich-Lösung im Volumenverhältnis 1:6 erzeugen.

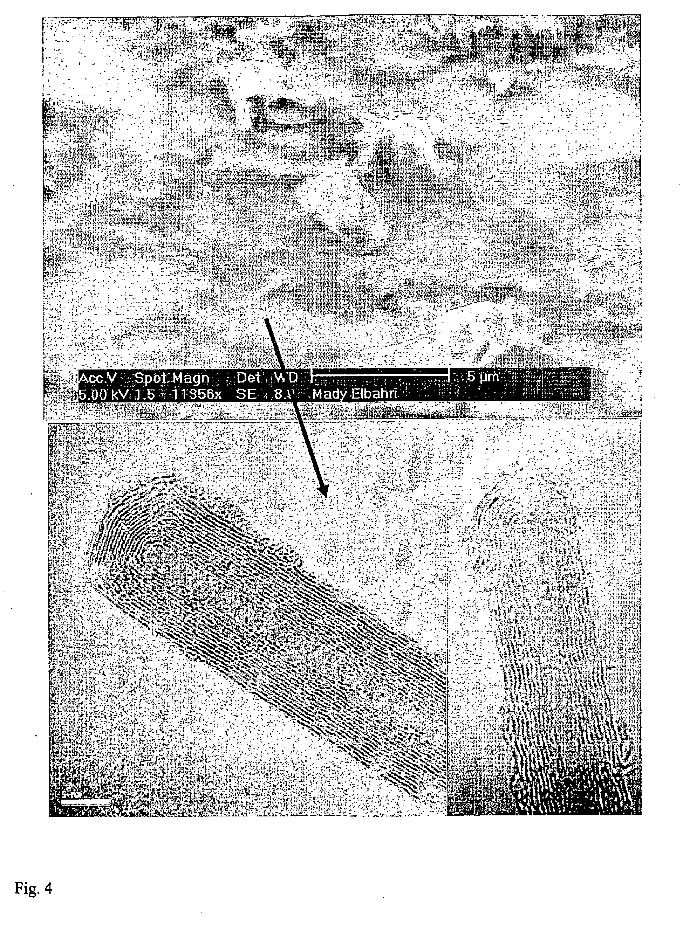

In Fig. 4 sind Transmissionselektronenmikroskop-Aufnahmen nach Verwendung derselben ZnO/NAOH/Aldrich Lösung zu sehen, in denen sich ein Netzwerk aus "multiwall carbon nanotubes" (MWCNT) ausmachen lässt (man beachte die Ausschnittsvergrößerungen). Kurioserweise liegen diese MWCNT von vornherein auf dem Substrat und bilden so ein elektrisch leitfähiges Geflecht. Der Kohlenstoff entstammt in den Beispielen dem Stabilisator der Aldrich-Lösung. Allerdings können die MWCNT auch ganz gezielt erzeugt werden, etwa wenn man eine reine Karbonat-Lösung auf das Substrat tropft.

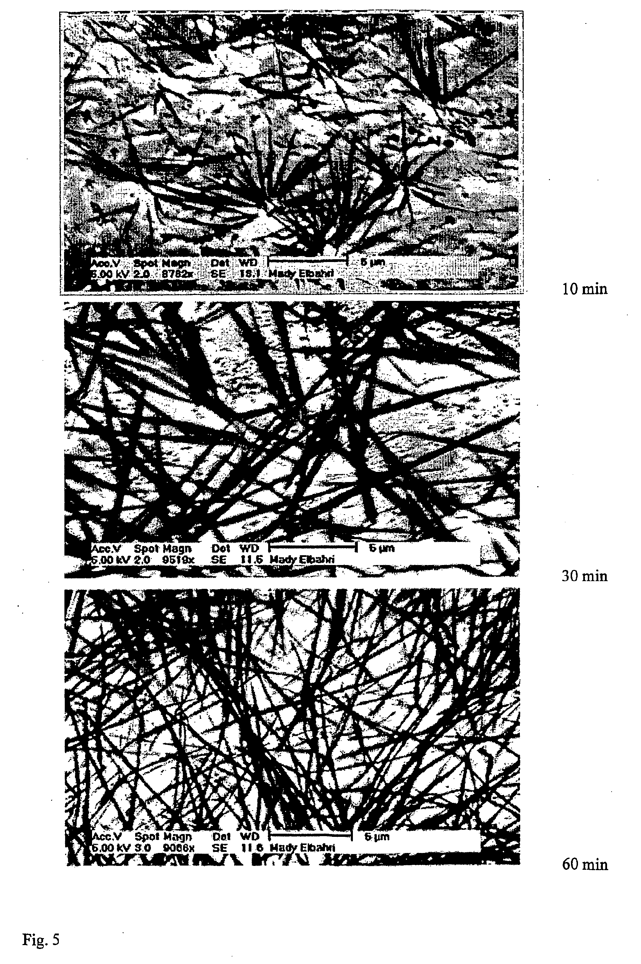

Lässt man das Substrat nach dem Betropfen mit der zuvor genannten Lösung weiterhin beheizt unter Raumluft ruhen, so wachsen abstehende Drähte (Büschel) von den in Fig. 4 ebenfalls gezeigten Kristallen aus. Im Laufe einer Stunde wachsen die Nanodrähte weiter, wobei die Bedeckungsdichte zunimmt und die Drahtdicke abnimmt. Dabei verjüngen sich anscheinend die bereits bestehenden Drähte, und es bilden sich neue mit geringerem Durchmesser. Die Drahtdurchmesser variieren zwischen anfangs 100 nm und später etwa 60 nm während die Länge von ca. 3 µm nach 15 Minuten bis zu 25 µm nach einer Stunde anwächst. Danach ist ein weiteres Wachstum der Drähte nicht mehr auszumachen, wenngleich es nicht völlig zum Stillstand gekommen sein muss. Fig. 5 zeigt die vom Substrat weg wachsenden Nanodrähte in den verschiedenen Stadien ihrer Bildung. Die Zeiten der Momentaufnahmen nach dem Aufbringen der Lösungstropfen sind neben den jeweiligen Bildern angegeben. Die senkrechten Drähte sind anorganisch und wasserlöslich. Sie bestehen aus Kohlenstoff (aus dem Stabilisator der Aldrich-Lösung), Natrium (aus der Natronlauge zum Lösen des ZnO) und Sauerstoff (vermutlich aus der Umgebungsluft).

Es sollte besonders darauf hingewiesen werden, dass in den bisher genannten Beispielen alle Nanostrukturen unmittelbar aus Ionen in Lösung entstanden sind (ausgenommen das fraktale Goldnetz, welches sich aus Goldkolloiden bildet). Es besteht also keine Notwendigkeit, vorab Nanopartikel in die Lösung zu geben, um diese auf dem Substrat abzulegen. Dies ist ein wesentlicher Unterschied zur herkömmlichen Deponierung z.B. von Kohlenstoff-Nanoröhren, die ansonsten zuvor in Pulverform vorliegen müssen. Gleichwohl kann das erfindungsgemäße Verfahren natürlich auch unter Beimengung von Nanopartikeln zur wässrigen Lösung durchgeführt werden, die danach aufgetropft wird.

Eine sehr vorteilhafte Ausgestaltung des erfindungsgemäßen Verfahrens besteht im Verkippen des Substrats gegen die Horizontale vor oder unmittelbar nach dem Aufbringen des Lösungstropfens.

Durch das. Verkippen des Substrates können Nanostrukturen relativ gezielt entlang einer Vorzugsrichtung (dem Neigungsgradienten) deponiert werden. Das zu bildende oder zu deponierende Material wird wie zuvor in Wasser gelöst bzw. suspendiert. Wie oben werden Substrate auf Temperaturen oberhalb 200 °C erhitzt. Dann werden Tröpfchen mit Durchmessern von ca. 1-2 mm auf die Oberfläche gebracht. Im Unterschied zum Bisherigen wird das Substrat verkippt, wobei der Kippwinkel nun die Tropfenablaufgeschwindigkeit bestimmt. Durch den Leidenfrost-Effekt schwebt auch hier das Tröpfchen auf einem Dampfpolster.

Durch Abgabe von Material aus dem Tropfen, die überwiegend am Tropfenrand stattfindet ("coffee stain effect"), werden Nanodots (Cluster) während des Tropfenlaufs entlang der Bewegungsrichtung auf dem Substrat abgelegt. Dies geschieht in relativ regelmäßigen Abständen in Abhängigkeit von der Laufgeschwindigkeit des Tropfens, mithin also vom eingestellten Kippwinkel. Liegen die Cluster ausreichend dicht, bilden sie faktisch einen Nanodraht, der z.B. elektrisch leiten kann. Zwischen den Clustern können sich Moleküle anlagern, was bei Anwendungen als chemischer Sensor zum Tragen kommen könnte. Es zeigt sich aber auch ein Sortierungseffekt hinsichtlich der Clustergröße: die größten bzw. schwersten Cluster werden zuerst deponiert, die kleineren erst später. Entlang der Laufrichtung der des Tropfens ändert sich also die Clustergrößenverteilung von groß nach klein, wobei sie lokal recht geringe Schwankung zeigt, d.h. ausgedehnte Drahtabschnitte bestehen aus etwa gleich großen Clustern.

Die Kipp-Deponierung steht in einem offensichtlichen Gegenverhältnis zum bekannten Lotus-Effekt, bei dem schwach haftendes Material von einem vorbeilaufenden Wassertropfen aufgesammelt und mitgenommen wird, weshalb sie die Bezeichnung "Anti-Lotus-Effekt" verdienen könnte.

Die Temperatur des Substrats oberhalb von 200 °C zur Erzwingung des Leidenfrost-Effekts spielt auch hier eine große Rolle, da sich das Gleiten des Tropfens auf seinem eigenen Wasserdampfkissen offenbar günstig auf die gleichmäßige Verteilung der im Nachhinein feststellbaren Verteilung der Nanodots auswirkt.

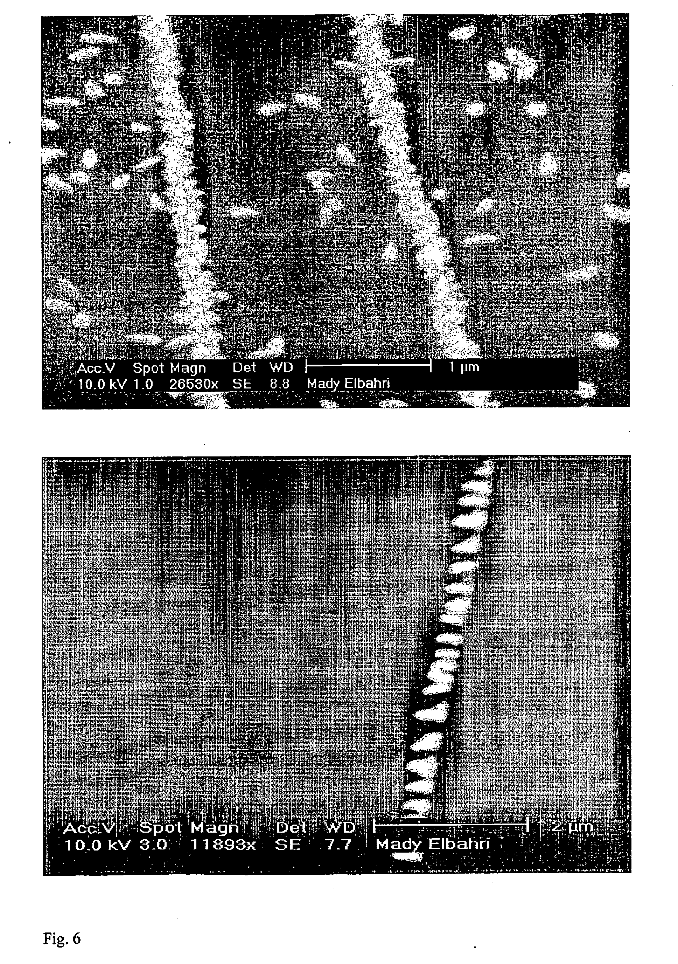

Ein Beispiel für die Anwendung des Anti-Lotus-Effektes, also die Kombination von Leidenfrost-Effekt, Coffee-Stain-Effekt und Verkippung ist in Fig. 6 zu sehen. In diesem Fall wird ein Tropfen aus Zinkacetat/Wasser (genau wie bei ZnO Nanostäbchen), benutzt. Das obere Bild zeigt parallel verlaufende Nanodrähte, die aus Nanostäbchen bestehen. Das untere zeigt einen Nanodraht aus voneinander separierten Nanodots. In beiden Fällen ergeben sich die Nanostrukturen innerhalb weniger Sekunden nach dem Auftropfen der ZnO-Lösung.

Ein weiteres Beispiel (nicht dargestellt) betrifft die Herstellung von Silberstrukturen. Es ist bekannt, dass die thermische Dekomposition von AgNO₃ (Silbernitrat) zu metallischem Silber bei 180 °C stattfindet, so dass sich in einem Schritt Fabrikation und Anordnung der Nanoteilchen in einem 1D Array realisieren lassen.

Anscheinend lassen sich viele verschiedene Materialien auf diesem Weg und ohne Template einfach und schnell herstellen. Forschungsarbeiten zum Ausloten des Potenzials der Erfindung stehen noch am Anfang. Klar ist bislang aber, dass die Schritte 1, 3, 4 und 5 des eingangs beschriebenen Verfahrens die notwendige Voraussetzung für eine noch weitgehend unverstandene Reaktionskinetik bei der Bildung von Nanostrukturen auf Substraten sind, wobei von den Substraten selbst nur verlangt werden muss, dass sie Temperaturen etwas oberhalb von 200 °C standhalten. Der Einfluss der Oberflächenrauheit des Substrates bleibt noch zu untersuchen. Bei den hier präsentierten Experimenten wurden monokristalline Silizium-Wafer ggf. mit SiO₂-Bedeckungsschicht verwendet.

## Patentansprüche

1. Verfahren zur Herstellung von Nanostrukturen auf einem Substrat,
**gekennzeichnet durch**
Auftropfen einer Lösung aus nanostrukturbildendem Material in Wasser auf das auf eine Temperatur oberhalb der Temperatur, bei der ein Tropfen der Lösung nach einem Auftropfen auf das Substrat zunächst auf einem Dampfpolster schwebt, erwärmte Substrat unter Ausbildung von Nanostrukturen beim Verdampfen der Tropfen.

2. Verfahren nach Anspruch 1, **dadurch gekennzeichnet, dass** die Temperatur des Substrats oberhalb von 200 °C eingerichtet wird.

3. Verfahren nach einem der vorangehenden Ansprüche, **dadurch gekennzeichnet, dass** das Substrat vor oder unmittelbar nach dem Betropfen gegen die Horizontale verkippt wird.

4. Verfahren nach einem der vorangehenden Ansprüche, **dadurch gekennzeichnet, dass** das Substrat nach dem Verdampfen der Tropfen für eine Dauer zwischen mehreren Minuten bis hin zu wenigen Stunden weiter beheizt wird, so dass vom Substrat abstehende Nanodrähte weiter wachsen.

5. Verfahren nach einem der vorangehenden Ansprüche, **dadurch gekennzeichnet, dass** der Lösung Katalysator-Nanopartikel aus Edelmetall beigemengt werden.

6. Verfahren nach Anspruch 5, **dadurch gekennzeichnet, dass** der Lösung Goldpartikel mit einem Durchmesser um 20 nm beigemengt werden.

## Claims

1. A method for producing nanostructures on a substrate,
**characterized in that**
a solution of nanostructure forming material in water is dripped onto said substrate at a temperature above the temperature at which a drop of the solution is initially suspended on a vapor cushion after being applied by dripping onto the substrate, with nanostructures being formed when the drops evaporate.

2. The method of claim 1, **characterized in that** the temperature of the substrate is adjusted to above 200 °C.

3. The method of one of the preceding claims, **characterized in that** the substrate is tilted against the horizontal plane before or immediately after having been dripped onto said substrate.

4. The method of one of the preceding claims, **characterized in that** the substrate is still heated between several minutes and a few hours after evaporation of the drop, so that distant nanowires continue growing.

5. The method of one of the preceding claims, **characterized in that** catalytic nanoparticles of noble metal are admixed to the solution.

6. The method of claim 5, **characterized in that** gold particles with a diameter of about 20 nm are admixed to the solution.

## Revendications

1. Procédé de production de nanostructures sur un substrat, **caractérisé par** le fait d'appliquer en gouttes sur le substrat une solution constituée par une matière dans l'eau qui forme une nanostructure, ledit substrat étant chauffé à une température supérieure à la température à laquelle une goutte de la solution, après son application sur le substrat, flotte d'abord sur un coussin de vapeur, des nanostructures étant formées lors de l'évaporation des gouttes.

2. Procédé selon la revendication 1, **caractérisé par le fait que** la température du substrat est réglée de manière à être supérieure à 200°C.

3. Procédé selon l'une quelconque des revendications précédentes, **caractérisé par le fait que**, avant d'appliquer ou immédiatement après avoir appliqué les gouttes, ledit substrat est basculé par rapport à l'horizontale.

4. Procédé selon l'une quelconque des revendications précédentes, **caractérisé par le fait que**, après l'évaporation des gouttes, ledit substrat est chauffé encore pour une durée comprise entre plusieurs minutes et quelques heures, de sorte que des nanofils faisant saillie du substrat continuent à croître.

5. Procédé selon l'une quelconque des revendications précédentes, **caractérisé par le fait que** l'on ajoute à la solution des nanoparticules de catalyseur en métal précieux.

6. Procédé selon la revendication 5, **caractérisé par le fait que** l'on ajoute à la solution des particules d'or ayant un diamètre de 20 nm à peu près.
